# EUROPÄISCHE PATENTANMELDUNG

(11) **EP 0 845 814 A2**
(43) Veröffentlichungstag der Anmeldung: **03.06.1998**
(21) Anmeldenummer: 97810843.9
(22) Anmeldetag: 10.11.1997
(51) Int. Cl.: H01L 29/744, H01L 29/08

(54) **Verfahren zur Herstellung eines GTO-Thyristors**

(30) Priorität: 02.12.1996 DE 19649800
(71) Anmelder: Asea Brown Boveri AG, 5401 Baden (CH)
(72) Erfinder: Galster, Norbert, 79774 Albbruck (DE); Klaka, Sven, 5415 Nussbaumen (CH); Weber, André, Dr., 4600 Olten (CH)
(74) Vertreter: Weibel, Beat

(57) **Zusammenfassung**

Zur Erzeugung eines hoch transparenten Anodenemitters (2) in einem GTO (1) wird ein zweistufiges Verfahren vorgeschlagen. In einem ersten Schritt wird ein Anodenemitter (2) eindiffundiert, dessen Dicke grösser 0.5 µm und dessen Dotierungskonzentration grösser 10¹⁷ cm⁻³ ist. Die Emittereffizienz des Anodenemitters (2) wird anschliessend in einem zweiten Schritt durch lokale Trägerlebensdauereinstellung auf ein gewünschtes Mass reduziert.

## Beschreibung

### Technisches Gebiet

Die Erfindung bezieht sich auf das Gebiet der Halbleiterelektronik. Sie geht aus von einem Verfahren zur Herstellung eines Abschaltthyristors mit einer anodenseitigen Stopschicht und einem transparenten Anodenemitter gemäss dem Oberbegriff des ersten Anspruchs.

### Stand der Technik

Ein solches Verfahren bzw. ein damit hergestellter Abschaltthyristor (GTO) ist bereits in der EP 0 621 640 A1 beschrieben. Unter einem transparenten Anodenemitter wird eine anodenseitige Emitterschicht verstanden, die so gestaltet ist, dass ein signifikanter Anteil des Gesamtstromes die Anodenmetallisierung des Bauelements als Elektronenstrom verlässt. Diesen in % des Gesamtstromes angegebenen Elektronenstrom bezeichnet man als Emittertransparenz. Technisch von Bedeutung sind Anodenemitter mit einer Transparenz von 50% und mehr. Einen gattungsgemässen transparenten Emitter erreicht man z.B. dadurch, dass eine Schichttiefe von 1.2 µm gewählt und eine Dotierungskonzentration von 10¹⁸ cm⁻³ eindiffundiert wird. Weitere transparente Anodenemitter werden in den Schriften EP 0 651 445 A2 und EP 0 700 095 A2 offenbart.

Auf Grund der guten Eigenschaften von GTOs mit Stopschicht und transparentem Anodenemitter werden immer transparentere, d.h. weniger dicke und weniger stark dotierte Anodenemitter gewünscht. Ein immer dünnerer und schwächer dotierter Anodenemitter führt jedoch zu erheblichen technischen Schwierigkeiten bei der Herstellung des metallischen Kontaktes der Anodenelektrode mit dem Anodenemitter. Beim Abscheiden des Aluminiums auf den Halbleiter wird das Silizium gelöst und beim Abkühlen wieder auskondensiert. Dies führt dazu, dass der Anodenemitter durch den Prozess der Metallisierung stark beeinflusst wird. Eine nachträgliche Sinterung, wie sie bei anderen GTOs üblich ist, um den Kontaktwiderstand zu senken, ist praktisch unmöglich.

### Darstellung der Erfindung

Aufgabe der vorliegenden Erfindung ist es deshalb, ein Verfahren zur Herstellung eines Abschaltthyristors mit einer anodenseitigen Stopschicht und einem transparenten Anodenemitter anzugeben, bei welchem die oben genannten Probleme bei der Herstellung der Anodenmetallisierung nicht auftreten.

Diese Aufgabe wird bei einem Verfahren der eingangs genannten Art durch die Merkmale des ersten Anspruchs gelöst.

Kern der Erfindung ist es also, dass zunächst ein problemlos handhabbarer Anodenemitter eindiffundiert wird, dessen Effizienz erst in einem zweiten Schritt mittels Trägerlebensdauereinstellung reduziert wird. Zur Trägerlebensdauereinstellung wird der Anodenemitter insbesondere mit Protonen oder Heliumkernen bestrahlt. Der zunächst erzeugte Anodenemitter weist vorzugsweise eine Dicke im Bereich von 0.5 µm bis 5 µm und eine Dotierungskonzentration zwischen 10¹⁷ cm⁻³ und 5 • 10¹⁸ cm⁻³ auf.

Weitere Ausführungsbeispiele ergeben sich aus den entsprechenden abhängigen Ansprüchen.

Der Vorteil des erfindungsgemässen Verfahrens besteht darin, dass durch die Zweiteilung des Herstellungsverfahrens des transparenten Emitters keine Probleme bei der Metallisierung auftreten. Der im ersten Schritt hergestellte Emitter kann problemlos metallisiert werden. Die gewünschte hohe Transparenz kann dann anschliessend im zweiten Schritt eingestellt werden.

### Kurze Beschreibung der Zeichnungen

Nachfolgend wird die Erfindung anhand von Ausführungsbeispielen im Zusammenhang mit den Zeichnungen näher erläutert.

Es zeigen:

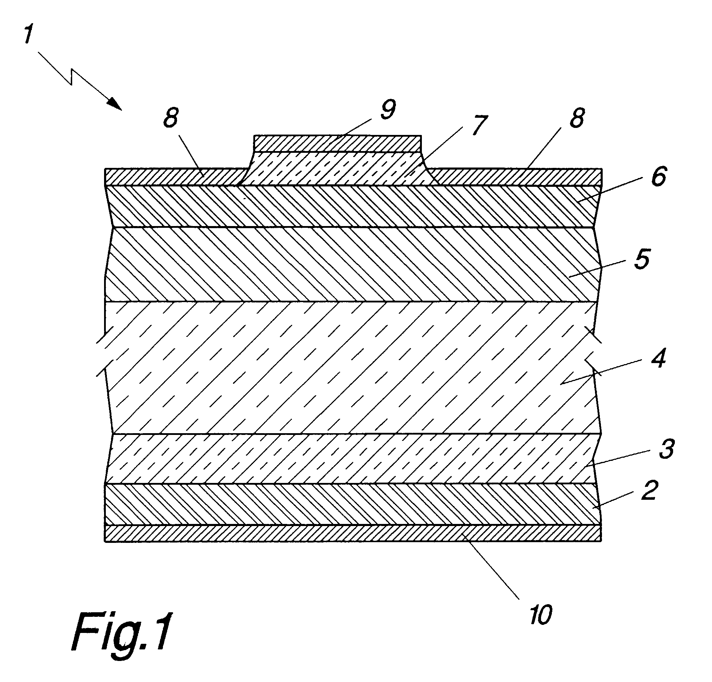

- **Fig. 1**: Einen Ausschnitt aus einem GTO, dessen transparenter Anodenemitter mit dem erfindungsgemässen Verfahren herstellbar ist.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

**Figur 1** zeigt einen Ausschnitt aus einem Abschaltthyristor oder GTO 1 im Schnitt. Mit einfach schraffierten Bereichen sind Metallisierungen dargestellt. N-dotierte Gebiete sind abwechselnd durchgehend und gestrichelt schraffiert. P-dotierte Gebiete sind mit zwei parallelen Linien schraffiert. Je dichter die Schraffur desto höher dotiert ist das entsprechende Gebiet. Der GTO 1 umfasst eine Anzahl von unterschiedlich dotierten Halbleiterschichten: Mit 2 ist ein vorzugsweise p-dotierter Anodenemitter bezeichnet. Daran anschliessend folgt eine n-dotierte Stopschicht 3 und eine schwächer n-dotierte n-Basis 4. Mit 5 ist eine p-Basis bezeichnet, an die ein etwas höher p-dotiertes Gategebiet 6 anschliesst. Mit 7 ist schliesslich ein Kathodenemitter oder Kathodenfinger bezeichnet. Der Kathodenemitter 7 kann wie dargestellt erhaben oder aber eindiffundiert ausgeführt werden.

Die eben erläuterte Struktur entspricht derjenigen eines üblichen GTOs. Seine Funktions- bzw. Herstellungsweise muss an dieser Stelle nicht speziell erläutert werden, da aus dem eingangs erwähnten Stand der Technik hinreichend bekannt. Für die Erfindung wesentlich ist das Verfahren zur Herstellung des Anodenemitters 2. Im Hinblick auf möglichst schnelle und verlustarme GTOs wäre im Zusammenhang mit der Stopschicht 3 ein möglichst transparenter Emitter 2 wünschenswert. Das heisst, er sollte eine möglichst geringe Dicke aufweisen und sehr schwach dotiert sein. Wie eingangs erwähnt führt dies jedoch zu Problemen beim Aufbringen der Metallisierung 10 auf den Anodenemitter 2.

Diese Probleme können durch das erfindungsgemässe Verfahren zur Herstellung des transparenten Emitters dadurch gelöst werden, dass der transparente Emitter 2 in einem ersten Schritt dicker gemacht und stärker dotiert wird als gewünscht, und die erforderliche Transparenz in einem zweiten Schritt mittels Trägerlebensdauereinstellung verwirklicht wird. Die Trägerlebensdauereinstellung erfolgt dabei vorzugsweise mittels Protonen- oder Heliumkernbestrahlung.

Der Anodenemitter 2 kann beispielsweise nach Massgabe der folgenden reproduzierbaren Bedingungen hergestellt werden:

Zunächst wird Anodenemitter 2 durch eine 10 bis 15-stündige Bor Implantation bei 1000° bis 1050° C eindiffundiert. Dadurch erreicht man ein resultierendes Dotierungsprofil mit einer Maximalkonzentration von ca. 5 • 10¹⁷ cm⁻³ und einer Eindringtiefe im Bereich von 1 µm bis 3 µm. Mit einer solchen Schicht ist eine Sinterung der nachfolgend aufgebrachten Anodenmetallisierung 10 noch möglich. Die benötigte schwache Effizienz des Anodenemitters, d.h. die hohe Transparenz, wird vor dem Aufbringen der Metallisierung 10 in einem zweiten Schritt durch Trägerlebensdauereinstellung vorgenommen. Dazu wird vorzugsweise eine Protonen- oder Heliumbestrahlung bis zu einer Tiefe appliziert, die grösser ist als die oben erwähnte Anodenemittereindringtiefe, aber geringer ist als die Eindringtiefe der Stopschicht 3 (z.B. 50 µm). Geeignete Strahlendosen liegen im Bereich von 10¹⁰ bis 10¹² Teilchen pro cm².

Das erfindungsgemässe zweistufige Herstellungsverfahren ermöglicht also die Realisierung eines transparenten Anodenemitters, der trotz seiner hohen Transparenz problemlos metallisiert werden kann. Dadurch kann der resultierende GTO bezüglich Durchlassverluste und Schaltverhalten weiter optimiert werden, ohne dass andere erwünschte Eigenschaften beeinträchtigt werden.

### Bezugszeichenliste

- 1: Abschaltthyristor, GTO
- 2: Anodenemitter
- 3: Stopschicht
- 4: n-Basis
- 5: p-Basis
- 6: Gategebiet
- 7: Kathodenemitter
- 8: Gatemetallisierung
- 9: Kathodenmetallisierung
- 10: Anodenmetallisierung

## Patentansprüche

1. Verfahren zur Herstellung eines Abschaltthyristors (1) mit einer anodenseitigen Stopschicht (3) und einem transparenten Anodenemitter (2), dadurch gekennzeichnet, dass in einem ersten Schritt ein Anodenemitter (2) erzeugt wird, dessen Dicke grösser 0.5 µm und kleiner 5 µm und dessen Dotierungskonzentration grösser 10¹⁷ cm⁻³ und kleiner als 5 • 10¹⁸ cm⁻³ ist, und dass in einem zweiten Schritt die Emittereffizienz des Anodenemitters (2) durch lokale Trägerlebensdauereinstellung auf ein gewünschtes Mass eingestellt wird.

2. Verfahren nach Anspruch 1, dadurch gekennzeichnet, dass die Trägerlebensdauereinstellung mittels Protonen- oder Heliumkernbestrahlung des Anodenemitters (2) vorgenommen wird.

3. Verfahren nach Anspruch 2, dadurch gekennzeichnet, dass der Anodenemitter (2) mit einer Strahlungsdosis zwischen 10¹⁰ cm⁻² und 10¹² cm⁻² bestrahlt wird.
